# EUROPEAN PATENT APPLICATION

(11) **EP 2 642 524 A2**
(43) Date of publication of application: **25.09.2013**
(21) Application number: 13160692.3
(22) Date of filing: 22.03.2013
(51) Int. Cl.: H01L 31/0216

(54) **Solar cell**

(30) Priority: 22.03.2012 KR 20120029554; 25.06.2012 US 201213531728; 15.03.2013 KR 20130028217
(71) Applicant: Samsung Electronics Co., Ltd, Gyeonggi-do 443-742 (KR)
(72) Inventor: Do, Eun Cheol, Gyeonggi-do, (KR); Kim, Dong Kyun, Gyeonggi-do, (KR); Kim, Yun Gi, Gyeonggi-do, (KR); Kim, Chul Ki, Gyeonggi-do (KR); Lee, Yeon II, Gyeonggi-do, (KR); Choi, Young Moon, Seoul, (KR)
(74) Representative: Zijlstra, Robert Wiebo Johan

(57) **Abstract**

A solar cell includes a semiconductor layer including a charge carrier produced therein upon exposure to light, and a passivation layer on a side of the semiconductor layer, the passivation layer configured to apply a stress to the semiconductor layer and change a mobility of the charge carrier into a direction in the semiconductor layer.

## Description

### FIELD OF THE INVENTION

Example embodiments provide a solar cell.

### BACKGROUND OF THE INVENTION

Primary energy sources currently used for humankind are fossil fuels, e.g., coals and petroleum. However, fossil fuels are being exhausted and cause global warming and environmental pollution. Solar light, tidal power, wind power, and/or geothermal heat are being studied as an alternative energy source for replacing fossil fuel.

Among them, a solar cell technology of converting solar light into electricity utilizes a material that produces holes and electrons to generate currents upon receipt of light. However, the efficiency of the solar cell may be insufficient due to the hole-electron recombination at a surface of a layer or a film in the solar cell.

### SUMMARY OF THE INVENTION

According to example embodiments, a solar cell may include a semiconductor layer including a charge carrier produced therein upon exposure to light, and a passivation layer on a side of the semiconductor layer, the passivation layer configured to apply a stress to the semiconductor layer and change a mobility of the charge carrier into a direction in the semiconductor layer.

The semiconductor layer may be P-type, and the stress applied to the semiconductor layer may be a tensile stress. A compressive stress may be applied to the semiconductor layer in the direction, and the compressive stress may be equal to or higher than 800 MPa.

The semiconductor layer may be N-type, and the stress applied to the semiconductor layer may be a compressive stress. A tensile stress may be applied to the semiconductor layer in the direction, and the tensile stress may be equal to or higher than 4,000 MPa.

The charge carrier may be electrons or holes. The passivation layer may include at least one of an oxide, a nitride, amorphous silicon, ZnS, and MgF₂. The solar cell may further include an anti-reflection coating on another side of the semiconductor layer. The anti-reflection coating may include at least one of MgF₂, ZnS, SiNₓ, SiO₂, and Al₂O₃.

The solar cell may further include a first electrode and a second electrode on a surface of the semiconductor layer, and the semiconductor layer may be connected to one of the first electrode and the second electrode. The first electrode and the second electrode may be on opposite sides of the semiconductor layer. The first electrode and the second electrode may be on a same side of the semiconductor layer.

According to example embodiments, a solar cell may include a semiconductor layer including a first charge carrier and a second charge carrier produced therein upon exposure to light, and a passivation layer on a side of the semiconductor layer, the passivation layer configured to apply a stress to the semiconductor layer and to reduce recombination of the first charge carrier and the second charge carrier in the semiconductor layer.

The semiconductor layer may be P-type, and the stress applied to the semiconductor layer may be a tensile stress. The semiconductor layer may be N-type, and the stress applied to the semiconductor layer may be a compressive stress.

The passivation layer may include at least one of an oxide, a nitride, amorphous silicon, ZnS and MgF₂.

The solar cell may further include an anti-reflection coating on another side of the semiconductor layer, and the anti-reflection coating may include at least one of MgF₂, ZnS, SiNₓ, SiO₂, and Al₂O₃.

The solar cell may further include a first electrode and a second electrode on opposite sides of the semiconductor layer, and the semiconductor layer may be connected to one of the first electrode and the second electrode.

According to example embodiments, a solar cell may include a semiconductor layer connected to one of a first electrode and a second electrode, the first and second electrodes disposed apart from each other, and a passivation layer on a side of the semiconductor layer, the passivation layer configured to apply a stress to the semiconductor layer and to control a mobility of a minority charge carrier in a direction.

The semiconductor layer may be P-type, and the stress applied to the semiconductor layer in the direction may be a compressive stress. The semiconductor layer may be N-type, and the stress applied to the semiconductor layer in the direction may be a tensile stress. The passivation layer may include at least one of an oxide, a nitride, amorphous silicon, ZnS and MgF₂.

### BRIEF DESCRIPTION OF THE DRAWINGS

Example embodiments will be more clearly understood from the following detailed description taken in conjunction with the accompanying drawings. FIGS. 1-11 represent non-limiting, example embodiments as described herein.
FIG. 1 is a schematic sectional view of a solar cell according to example embodiments.
FIGS. 2 and 3 are perspective views schematically showing stress applied on a semiconductor layer of a solar cell according to example embodiments.
FIGS. 4 and 5 are sectional views schematically showing stress applied on a semiconductor layer and a passivation layer of a solar cell according to example embodiments.
FIG. 6 is a graph showing the open-circuit voltage of a solar cell as function of impurity concentration in a semiconductor layer of the solar cell for various materials for a passivation layer of the solar cell.
FIG. 7 is a schematic sectional view of a solar cell according to example embodiments.
FIG. 8 is a graph showing the efficiency of a solar cell including a P-type substrate as function of strength of a vertical stress on the substrate.
FIG. 9 is a graph showing the efficiency of a solar cell including an N-type substrate as function of strength of a vertical stress on the substrate.
FIGS. 10 and 11 are schematic sectional views of solar cells according to example embodiments.

### DETAILED DESCRIPTION OF THE EMBODIMENTS

Example embodiments will be described more fully hereinafter with reference to the accompanying drawings. As those skilled in the art would realize, the described embodiments may be modified in various different ways, all without departing from the spirit or scope. In the drawings, parts having no relationship with the explanation are omitted for clarity, and the same or similar reference numerals designate the same or similar elements throughout the specification.

It will be understood that, although the terms "first", "second", etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of example embodiments.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises", "comprising", "includes" and/or "including," if used herein, specify the presence of stated features, integers, steps, operations, elements, and/or components, but do not preclude the presence or addition of one or more other features, integers, steps, operations, elements, components, and/or groups thereof.

Example embodiments are described herein with reference to cross-sectional illustrations that are schematic illustrations of idealized embodiments (and intermediate structures) of example embodiments. As such, variations from the shapes of the illustrations as a result, for example, of manufacturing techniques and/or tolerances, are to be expected. Thus, example embodiments should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of example embodiments.

Unless otherwise defined, all terms (including technical and scientific terms) used herein have the same meaning as commonly understood by one of ordinary skill in the art to which example embodiments belong. It will be further understood that terms, such as those defined in commonly-used dictionaries, should be interpreted as having a meaning that is consistent with their meaning in the context of the relevant art and will not be interpreted in an idealized or overly formal sense unless expressly so defined herein.

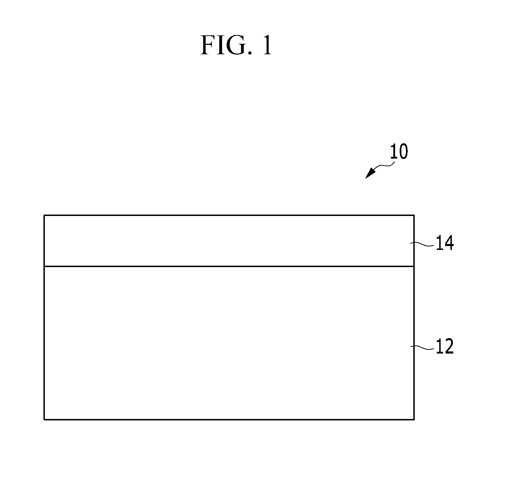

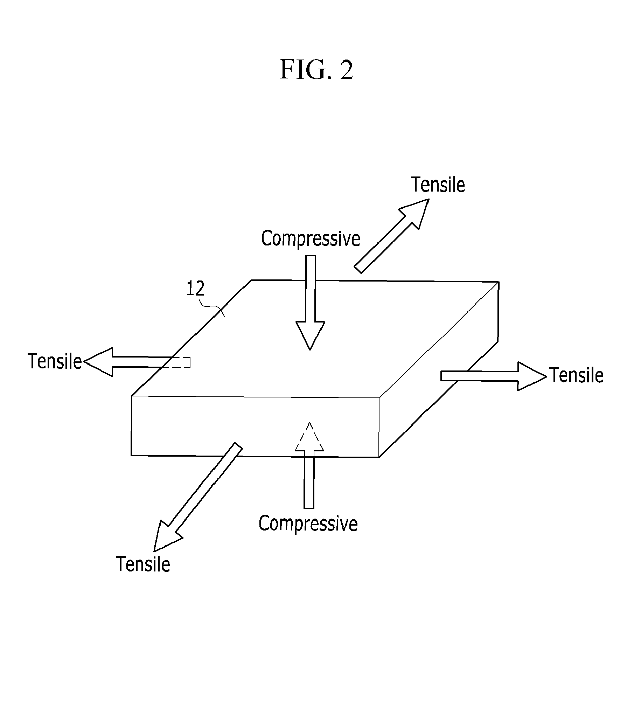

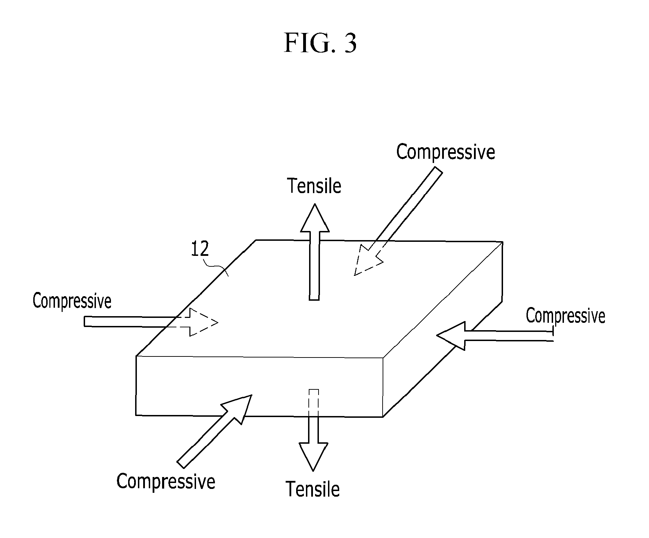

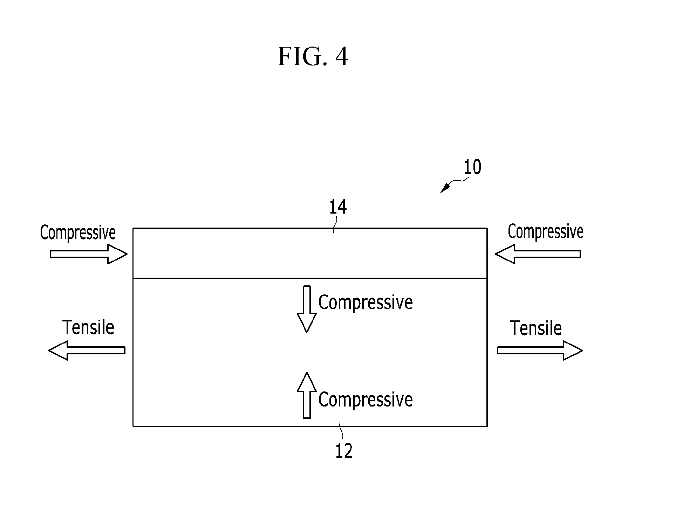

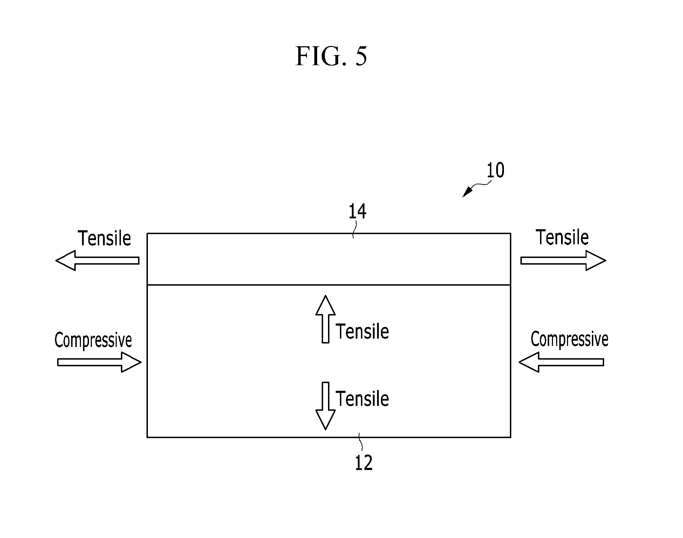

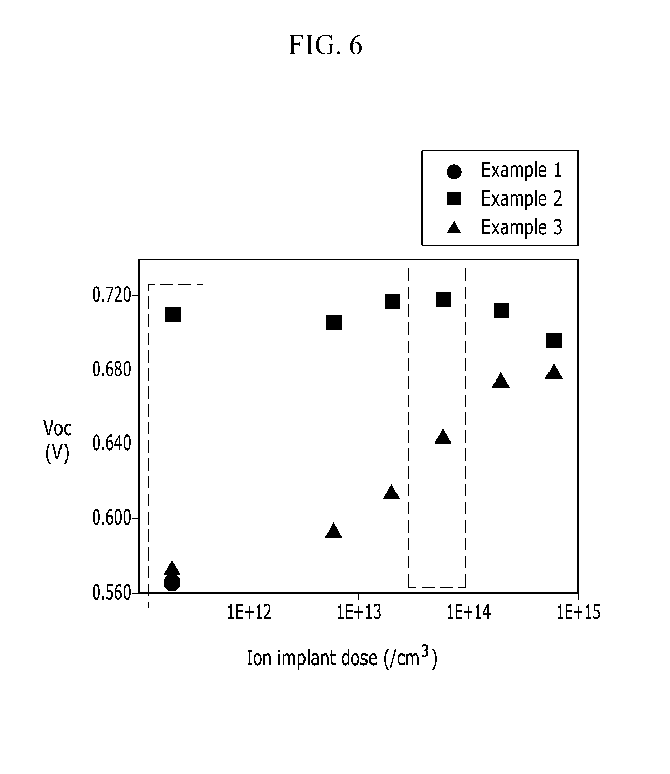

A solar cell according to example embodiments is described in detail with reference to FIGS. 1 to 5. FIG. 1 is a schematic sectional view of a solar cell according to example embodiments, FIGS. 2 and 3 are perspective views schematically showing stress applied on a semiconductor layer of a solar cell according to example embodiments, FIGS. 4 and 5 are sectional views schematically showing stress applied on a semiconductor layer and a passivation layer of a solar cell according to example embodiments, and FIG. 6 is a graph showing the open-circuit voltage of a solar cell as function of impurity concentration in a semiconductor layer of the solar cell for various materials for a passivation layer of the solar cell.

Referring to FIG. 1, a solar cell 10 according to example embodiments may include a semiconductor layer 12 and a passivation layer 14 disposed on the semiconductor layer 12. The semiconductor layer 12 may be a single crystalline silicon substrate, and may include P-type or N-type impurity of relatively low concentration. The semiconductor layer 12 may produce charge carriers, for example, electrons and holes.

The semiconductor layer 12 is configured to compressive or tensile stress in a direction (referred to as "a vertical direction" hereinafter) substantially perpendicular to a boundary surface between the semiconductor layer 12 and the passivation layer 14. When a type of stress in the vertical direction is applied to the semiconductor layer 12, an opposite type of stress may be applied in a direction (referred to as "a horizontal direction" hereinafter) substantially parallel to the boundary surface between the semiconductor layer 12 and the passivation layer 14.

The type of stress exerted on the semiconductor layer 12 may be determined to change or control the mobility of charge carriers in the semiconductor layer 12 in a predetermined or given direction, for example, such that recombination of minority charge carriers and majority charge carriers in the semiconductor layer 12 is reduced.

For example, when the semiconductor layer 12 includes a P-type impurity, holes are majority charge carriers and electrons are minority charge carriers. Referring to FIG. 2, a compressive stress in the vertical direction may be exerted on the P-type semiconductor layer 12, and in this case, a tensile stress in the horizontal direction may be exerted on the semiconductor layer 12. Then, the mobility in the vertical direction of the majority charge carriers, e.g., holes, may be raised while the mobility in the horizontal direction of the holes may be reduced. On the contrary, the vertical mobility of the minority charge carriers, e.g., electrons may be decreased while the horizontal mobility of the electrons may be increased. Therefore, the number of the minority charge carriers, e.g., the electrons, that after being produced in the semiconductor layer 12, arrive at the boundary surface between the semiconductor layer 12 and the passivation layer 14 may be reduced, and thus, the recombination of the holes and the electrons may be reduced.

When the semiconductor layer 12 includes N-type impurity, electrons are majority charge carriers and holes are minority charge carriers. Referring to FIG. 3, a tensile stress in the vertical direction may be exerted on the N-type semiconductor layer 12, and a compressive stress in the horizontal direction may be exerted on the semiconductor layer 12. Then, the vertical mobility of the majority charge carriers, e.g., electrons, may be raised while the horizontal mobility of the electrons may be reduced. On the contrary, the vertical mobility of the minority charge carriers, e.g., holes, may be decreased while the horizontal mobility of the holes may be increased. Therefore, the number of the minority charge carriers, e.g., the holes, that after being produced in the semiconductor layer 12, arrive at the boundary surface between the semiconductor layer 12 and the passivation layer 14 may be reduced, and thus the recombination of the holes and the electrons may be reduced.

The passivation layer 14 contacts and covers a surface of the semiconductor layer 12 to protect the surface of the semiconductor layer 12. According to example embodiments, the stress exerted on the semiconductor layer 12 may be caused by the passivation layer 14. The passivation layer 14 may be formed such that the passivation layer 14 may suffer a type of stress opposite to the stress exerted on the semiconductor layer 12.

Referring to FIG. 4, the passivation layer 14 may be configured to suffer a compressive stress in the horizontal direction when the semiconductor layer 12 has a P-type conductivity. When a compressive stress in the horizontal direction is exerted on the passivation layer 14, the semiconductor layer 12 may suffer a tensile stress in the horizontal direction and a compressive stress in the vertical direction. Therefore, the vertical mobility the majority charge carriers, e.g., the holes, may be increased and the vertical mobility of the minority charge carriers, e.g., the electrons, may be decreased such that the recombination of the holes and the electrons at the boundary surface between the semiconductor layer 12 and the passivation layer 14 may be reduced.

Referring to FIG. 5, the passivation layer 14 may be configured to suffer a tensile stress in the horizontal direction when the semiconductor layer 12 has an N-type conductivity. When a tensile stress in the horizontal direction is exerted on the passivation layer 14, the semiconductor layer 12 may suffer a compressive stress in the horizontal direction and a tensile stress in the vertical direction. Therefore, the vertical mobility the majority charge carriers, e.g., the electrons, may be increased and the vertical mobility of the minority charge carriers, e.g., the holes, may be decreased such that the recombination of the holes and the electrons at the boundary surface between the semiconductor layer 12 and the passivation layer 14 may be reduced.

As described above, example embodiments provide the passivation layer 14 that is configured to differentiate the type of stress depending on the conductivity of the semiconductor layer 12. Accordingly, the number of the minority charge carriers that reach the boundary surface of the semiconductor layer 12 and the passivation layer 14 may be reduced, and thus, the recombination of the majority charge carriers and the minority charge carriers may be reduced to increase the efficiency of the solar cell 10.

Examples of materials for the passivation layer 14 may include oxides, e.g., SiO₂ and Al₂O₃, nitrides, e.g., SiNₓ, amorphous silicon, ZnS, MgF₂, or combinations thereof. When the passivation layer 14 includes a nitride, ZnS, or MgF₂, the passivation layer 14 may prevent or inhibit light reflection as well as protect the surface of the semiconductor layer 12.

The semiconductor layer 12 may have a thickness of 1 µm to 500 µm, and the passivation layer 14 may have a thickness of 5 nm to 500 nm.

In order to obtain a desired type of stress exerted on the passivation layer 14, the size of the lattice of the passivation layer 14 may be adjusted. For example, when the lattice of the passivation layer 14 is larger than the lattice of the semiconductor layer 12, a vertical stress applied to the semiconductor layer 12 by the passivation layer 14 may be compressive. On the contrary, the passivation layer 14 with the lattice smaller than the lattice of the semiconductor layer 12 may apply a tensile vertical stress to the semiconductor layer 12.

The lattice constant may vary depending on temperature, and in general, the lattice constant may be decreased as the temperature becomes lower. The passivation layer 14 may be formed by deposition at a relatively high temperature and by subsequent cooling to a room temperature, and the lattice constants of the passivation layer 14 and the semiconductor layer 12 may be lowered after the cooling process.

The degree of lattice constant decrease of each of the passivation layer 14 and the semiconductor layer 12 due to the cooling may depend on its coefficient of thermal expansion. Therefore, desired stress may be obtained in consideration of the difference in the coefficient of thermal expansion between the passivation layer 14 and the semiconductor layer 12.

For example, when the coefficient of thermal expansion of the passivation layer 14 is smaller than the coefficient of thermal expansion of the semiconductor layer 12, the lattice constant decrease of the passivation layer 14 may be smaller than the lattice constant decrease of the semiconductor layer 12. Therefore, the vertical stress on the semiconductor layer 12 by the passivation layer 14 (or the horizontal stress exerted on the passivation layer 14) may be compressive. On the contrary, when the coefficient of thermal expansion of the passivation layer 14 is greater than the coefficient of thermal expansion of the semiconductor layer 12, the lattice constant decrease of the passivation layer 14 may be greater than the lattice constant decrease of the semiconductor layer 12. Therefore, the vertical stress on the semiconductor layer 12 by the passivation layer 14 may be tensile.

The coefficient of thermal expansion of silicon for the semiconductor layer 12 is known to be about 2.6×10⁻⁶/°C. Among the materials for the passivation layer 14, the coefficient of thermal expansion of Si₃N₄ is known to be about 3.3×10⁻⁶/°C, the coefficient of thermal expansion of SiO₂ is known to be about 0.5×10⁻⁶/°C, and the coefficient of thermal expansion of Al₂O₃ is known to range from about 7.2×10⁻⁶/°C to about 7.8×10⁻⁶/°C.

Because the coefficients of thermal expansion of Si₃N₄ and silicon are similar to each other, the semiconductor layer 12 may suffer a compressive vertical stress or a tensile vertical stress. Because SiO₂ has the coefficient of thermal expansion smaller than silicon, the vertical stress exerted on the semiconductor layer 12 by the SiO₂ passivation layer 14 may be compressive.

Because Al₂O₃ has a coefficient of thermal expansion greater than silicon, the vertical stress exerted on the semiconductor layer 12 by the Al₂O₃ passivation layer 14 may be tensile.

In addition, the lattice constant decrease of the passivation layer 14 and the semiconductor layer 12 may be larger as the difference between the deposition temperature of the passivation layer 14 and the room temperature becomes larger, or the deposition temperature of the passivation layer 14 becomes higher. Therefore, as the deposition temperature of the passivation layer 14 becomes higher, the difference in the lattice constant between the passivation layer 14 and the semiconductor layer 12 becomes larger. Thus, the strength of the stress exerted on the semiconductor layer 12 by the passivation layer 14 may be increased.

When the passivation layer 14 is a thermal oxide, a horizontal stress suffered by the passivation layer 14 may be a compressive stress of about 350 MPa. When the passivation layer 14 is an oxide formed by plasma enhanced chemical vapor deposition (PECVD), a horizontal stress suffered by the passivation layer 14 may be a compressive stress of about 400 MPa. When the passivation layer 14 is a SiN layer formed by low pressure chemical vapor deposition (LPCVD), a horizontal stress suffered by the passivation layer 14 may be a compressive stress of about 700 MPa to about 1200 MPa.

In contrast, when the passivation layer 14 is a SiN layer formed by PECVD, a horizontal stress suffered by the passivation layer 14 may have a strength of about - 300 MPa to about 850 MPa, and may be tensile or compressive. When the passivation layer 14 is an Al₂O₃ layer formed by atomic layer deposition (ALD), the stress suffered by the passivation layer 14 may be a tensile stress of about -300 MPa to about -1.36 GPa.

The passivation layer 14 may be amorphous, and thus the strength of the stress exerted on the passivation layer 14, or the strength of the stress exerted on the semiconductor layer 12 by the passivation layer 14 may depend on the density or the degree of the crystallinity of the passivation layer 14 as well as on the difference in the lattice constant between the semiconductor layer 12 and the passivation layer 14, which may be determined by the process conditions of the passivation layer 14, for example, deposition temperature, RF frequency of the deposition, and/or vacuum degree. Therefore, the passivation layer 14 with a desired type of stress may be obtained by controlling the process conditions.

According to example embodiments, the passivation layer 14 may include a piezoelectric material such that a desired stress may be generated by applying a voltage to the passivation layer 14.

With various materials for the passivation layer 14 and various implant dosages of N-type impurity, e.g., phosphorous (P), implanted into the semiconductor layer 12, a solar cell 10 having a structure shown in FIG. 1 was manufactured, and the open-circuit voltage Voc of the solar cell 10 was measured, which is shown in FIG. 6. A semiconductor layer 12 of the solar cell has an N-type conductivity. A passivation layer 14 according to Experimental Example 1 is a thermal oxide layer having a thickness of about 10 nm, a passivation layer 14 according to Experimental Example 2 is a Si-rich SiNx layer having a thickness of about 130 nm, and a passivation layer 14 according to Experimental Example 3 is a PECVD SiO₂ layer having a thickness of about 200 nm. Referring to FIG. 6, for the N-type semiconductor layer 12, the solar cell 10 including the Si-rich SiNx passivation layer 14 has the highest value of the open-circuit voltage Voc. The Si-rich SiNx passivation layer 14 may suffer a tensile horizontal stress.

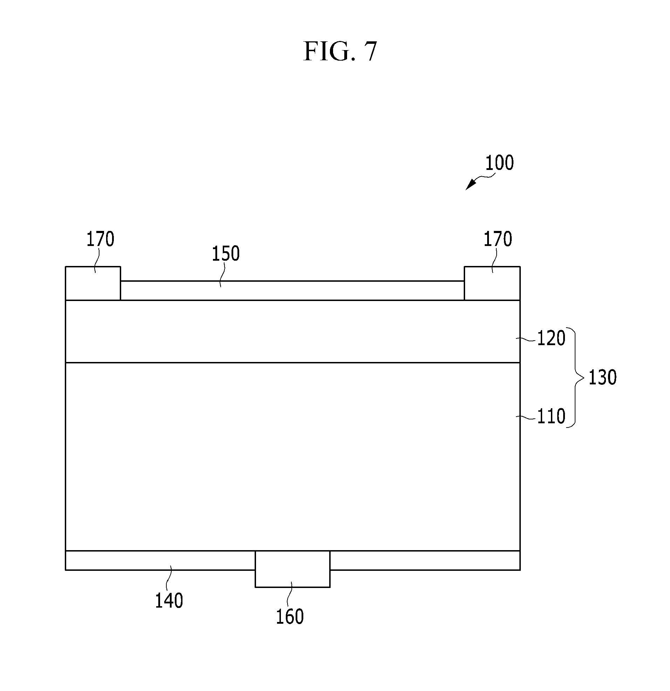

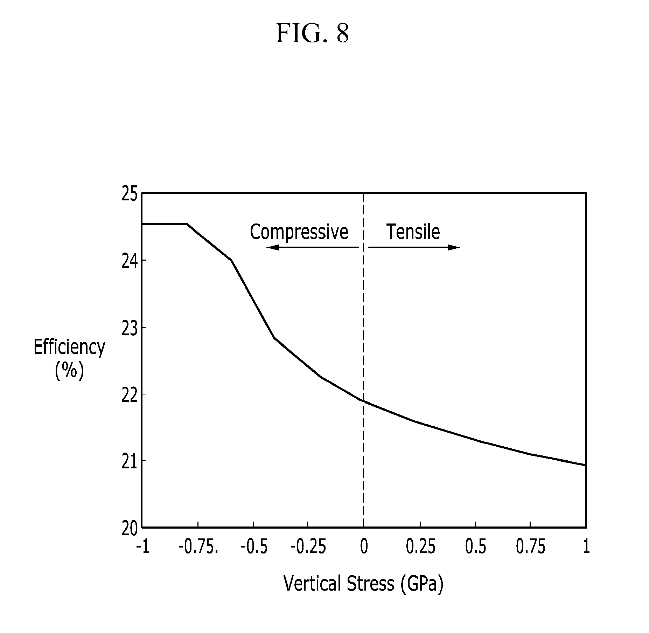

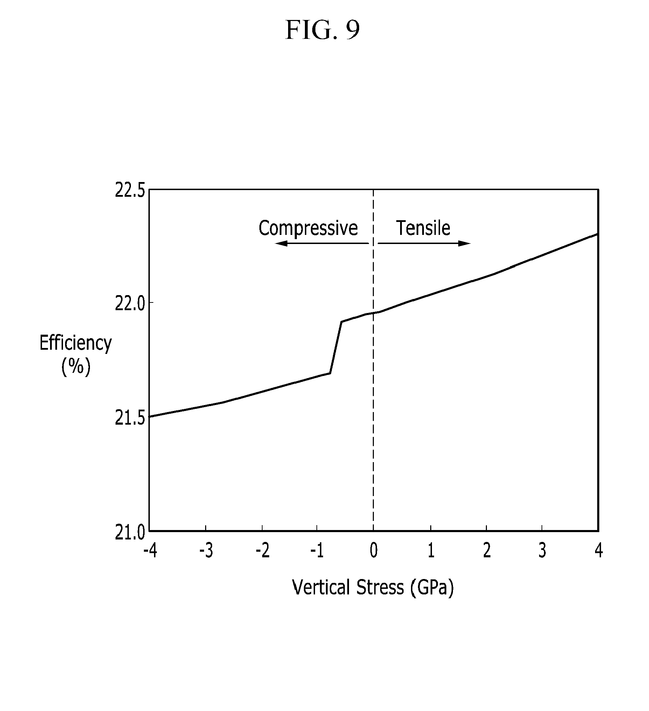

Now, characteristics of a solar cell according to example embodiments are described in detail with reference to FIGS. 7 to 9. FIG. 7 is a schematic sectional view of a solar cell according to example embodiments, FIG. 8 is a graph showing the efficiency of a solar cell including a P-type substrate as function of strength of a vertical stress on the substrate, and FIG. 9 is a graph showing the efficiency of a solar cell including an N-type substrate as function of strength of a vertical stress on the substrate.

Referring to FIG. 7, a solar cell 100 according to example embodiments may include a semiconductor substrate 110, an emitter 120, a passivation layer 140, an anti-reflection coating 150, a substrate electrode 160, and an emitter electrode 170. The semiconductor substrate 110 may be a semiconductor layer.

The semiconductor substrate 110 and the emitter 120 have opposite conductivities and are in contact with each other to form a PN junction 130. For example, when the semiconductor substrate 110 is P-type, the emitter 120 is N-type. On the contrary, when the semiconductor substrate 110 is N-type, the emitter 120 is P-type.

The semiconductor substrate 110 may be a single crystalline silicon substrate, and the emitter 120 may be formed by implanting an impurity into the substrate 110 having a conductivity opposite to the conductivity of the substrate 110. The passivation layer 140 contacts a substrate-side surface of the PN junction 130.

The anti-reflection coating 150 may be disposed on an emitter-side surface of the PN junction 130 and may prevent or inhibit the reflection of incident light to improve the efficiency of the solar cell 100. The anti-reflection coating 150 may also cover and protect the emitter-side surface of the PN junction 130. Examples of the anti-reflection coating 150 may include at least one of MgF₂, ZnS, SiNₓ, SiO₂, and Al₂O₃. The anti-reflection coating 150 may be omitted.

The substrate electrode 160 may be connected to the substrate 110 through a contact hole (not shown) in the passivation layer 140, and the emitter electrode 170 may be connected to the emitter 120 through a contact hole (not shown) in the anti-reflection coating 150. Materials for the electrodes 160 and 170 may include, for example, at least one of metals, e.g., Al, Ag, Au, and Cu or at least one of transparent conducting oxides (TCO).

The substrate 110 may have a thickness from 1 µm to 500 µm, the emitter 120 may have a thickness from 0.1 µm to 10 µm, the passivation layer 140 may have a thickness from 5 nm to 500 nm, and the anti-reflection coating 150 may have a thickness from 5 nm to 500 nm.

In the solar cell 100 having a structure shown in FIG. 7, by varying a stress exerted on a surface of the substrate 110 by the passivation layer 140, short-circuit current density (JSC), open-circuit voltage (VOC), fill factor (FF), and efficiency (Eff) were calculated by using Synopsys Technology Computer-Aided Design (TCAD) computer simulation.

A result of a simulation for a solar cell 100 with a P-type substrate 110 and an N-type emitter 120 is shown in Table 1 and FIG. 8.

**Table 1**

| Vertical Stress (MPa) | Horizontal Stress (MPa) | Jsc | Voc | FF | Eff |
|---|---|---|---|---|---|
| 1000 | -500 | 40.25 | 0.629 | 82.64 | 20.93 |
| 800 | -400 | 40.37 | 0.631 | 82.65 | 21.06 |
| 600 | -300 | 40.51 | 0.633 | 82.71 | 21.21 |
| 400 | -200 | 40.67 | 0.636 | 82.75 | 21.39 |
| 200 | -100 | 40.85 | 0.639 | 82.82 | 21.61 |
| 0 | 0 | 41.06 | 0.643 | 82.89 | 21.88 |
| -200 | 100 | 41.31 | 0.649 | 83.01 | 22.26 |
| -400 | 200 | 41.62 | 0.660 | 83.17 | 22.83 |
| -600 | 300 | 42.01 | 0.685 | 83.49 | 24.01 |
| -800 | 400 | 42.08 | 0.699 | 83.49 | 24.55 |
| -1000 | 500 | 42.08 | 0.699 | 83.49 | 24.55 |

Referring to Table 1 and FIG. 8, when the substrate 110 has a P-type conductivity, the solar cell 100 without stress on the substrate 110 shows an efficiency of about 21.88 %. The efficiency Eff becomes higher as the vertical stress on the substrate 110 becomes more compressive. For example, the efficiency EFF for the stress equal to or smaller than about -800 MPa is about 24.55 %, which is higher by about 2.67% compared with the case without stress. On the contrary, the efficiency Eff becomes lower as the vertical stress on the substrate 110 is more tensile.

A result of a simulation for a solar cell 100 with an N-type substrate 110 and a P-type emitter 120 is shown in Table 2 and FIG. 9.

**Table 2**

| Vertical Stress (MPa) | Horizontal Stress (MPa) | Jsc | Voc | FF | Eff |
|---|---|---|---|---|---|
| 4000 | -2000 | 40.76 | 0.661 | 82.81 | 22.31 |
| 2000 | -1000 | 40.59 | 0.659 | 82.76 | 22.12 |
| 1000 | -500 | 40.52 | 0.657 | 82.74 | 22.04 |
| 600 | -300 | 40.49 | 0.657 | 82.73 | 22.01 |
| 200 | -100 | 40.46 | 0.657 | 82.72 | 21.97 |
| 0 | 0 | 40.44 | 0.656 | 82.71 | 21.96 |
| -200 | 100 | 40.43 | 0.656 | 82.71 | 21.95 |
| -600 | 300 | 40.40 | 0.656 | 82.71 | 21.92 |
| -1000 | 500 | 40.70 | 0.648 | 82.23 | 21.68 |
| -2000 | 1000 | 40.64 | 0.647 | 82.21 | 21.61 |
| -4000 | 2000 | 40.53 | 0.645 | 82.22 | 21.5 |

Referring to Table 2 and FIG. 9, when the substrate 110 has an N-type conductivity, the solar cell 100 without stress on the substrate 110 shows an efficiency of about 21.96 %. The efficiency Eff becomes higher as the vertical stress on the substrate 110 becomes more tensile. For example, the efficiency EFF for the stress equal to or smaller than about 4000 MPa is about 22.31 %. On the contrary, the efficiency Eff becomes lower as the vertical stress on the substrate 110 is more compressive.

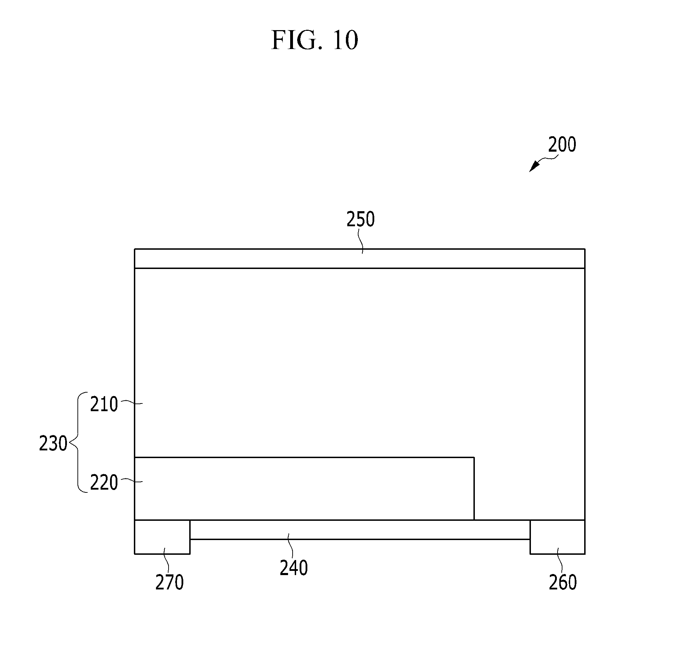

A solar cell according to example embodiments is described in detail with reference to FIG. 10. FIG. 10 is a schematic sectional view of a solar cell according to example embodiments.

Referring to FIG. 10, a solar cell 200 according to example embodiments includes a PN junction 230, a passivation layer 240, an anti-reflection coating 250, a substrate electrode 260, and an emitter electrode 270. The detailed descriptions of each portion of the solar cell 200 may be omitted because the structure of the solar cell 200 is similar to the solar cell 100 shown in FIG. 7, and features of the solar cell 200 distinguished from the solar cell 100 shown in FIG. 7 are mainly described.

The PN junction 230 includes a substrate 210 and an emitter 220 that have different conductivities, like FIG. 7. However, the emitter 220 is disposed under the substrate 210 according to example embodiments as illustrated in FIG. 10 while the emitter 120 is disposed on the substrate 110 in FIG. 7.

Because the emitter 220 in the solar cell 200 shown in FIG. 10 is disposed under the substrate 210, the anti-reflection coating 250 is placed on a top surface of the PN junction 230 on which light is incident, and the passivation layer 240 is disposed under the PN junction 230. The anti-reflection coating 250 shown in FIG. 10 may serve as a passivation layer, and may apply a stress on the semiconductor substrate 210 to improve the efficiency of the solar cell 200.

In addition, the substrate electrode 260 and the emitter electrode 270 in FIG. 10 are disposed at the same side of the PN junction 230 while the substrate electrode 160 and the emitter electrode 170 are disposed opposite each other as shown in FIG. 7. In order to obtain the structure where the electrodes 260 and 270 are at the same side, both the substrate 210 and the emitter 220 may be exposed at a surface of the PN junction 230. In detail, a portion of a bottom surface of the substrate 210 is covered by the emitter 220 and another portion of the bottom surface of the substrate 210 is not covered by the emitter 220 to be exposed in example embodiments as shown in FIG. 10 while the emitter 120 covers an entire surface of the substrate 110 as shown in FIG. 7.

When the electrodes 260 and 270 are disposed under the PN junction 230 as shown in FIG. 10, the area exposed to incident light is relatively wide, and thus the efficiency may be relatively high.

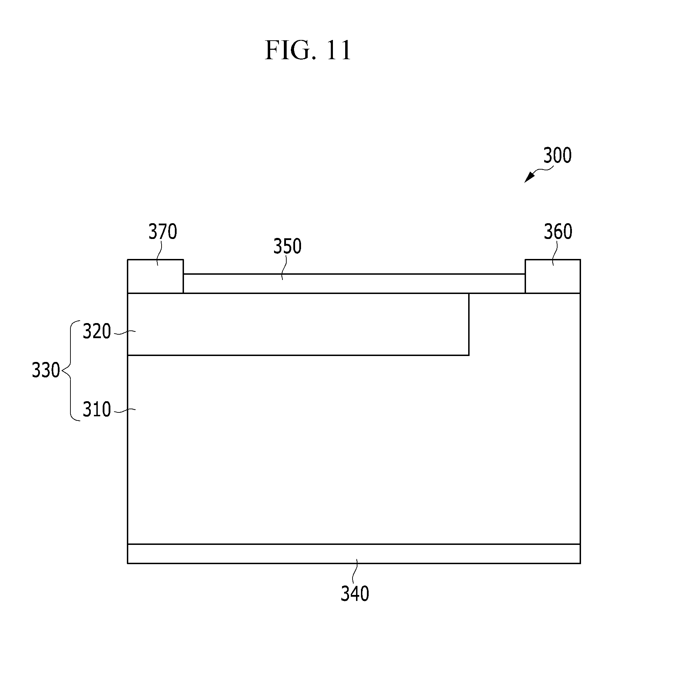

A solar cell according to example embodiments is described in detail with reference to FIG. 11. FIG. 11 is a schematic sectional view of a solar cell according to example embodiments.

Referring to FIG. 11, a solar cell 300 according to example embodiments includes a PN junction 330, a passivation layer 340, an anti-reflection coating 350, a substrate electrode 360, and an emitter electrode 370. The detailed descriptions of each portion of the solar cell 300 may be omitted since the structure of the solar cell 300 is similar to the solar cell 100 shown in FIG. 7, and features of the solar cell 300 distinguished from the solar cell 100 shown in FIG. 7 are mainly described.

The PN junction 330 includes a substrate 310 and an emitter 320 that have different conductivities, and the emitter 320 is disposed on the substrate 310, similar to example embodiments as shown in FIG. 7. However, both the substrate electrode 360 and the emitter electrode 370 in FIG. 11 are disposed on the top surface of the PN junction 330 while the substrate electrode 160 and the emitter electrode 170 are disposed opposite each other as shown in FIG. 7, and both the substrate 310 and the emitter 320 are exposed at the top surface of the PN junction 330. In detail, a portion of a top surface of the substrate 310 is covered by the emitter 320 and another portion of the top surface of the substrate 310 is not covered by the emitter 320 to be exposed in example embodiments as shown in FIG. 11 while the emitter 120 covers an entire surface of the substrate 110 as shown in FIG. 7.

A solar cell 300 having a structure shown in FIG. 11 were manufactured by varying a material for a passivation layer 340, and open-circuit voltage (VOC), short-circuit current density (JSC), fill factor (FF), and efficiency (Eff) of the solar cell 300 were measured, which are shown in Table 3. A substrate 310 of the solar cell 300 was N-type, and an emitter 320 was P-type. The passivation layer 340 according to Experimental Example 4 was a PECVD SiO₂ layer, the passivation layer 340 according to Experimental Example 5 was a N-rich SiNx layer, and the passivation layer 340 according to Experimental Example 6 was a Si-rich SiNx layer.

**Table 3**

| Characteristics (Unit) | Example 4 | Example 5 | Example 6 |
|---|---|---|---|
| Voc (mV) | 642 | 646 | 662 |
| Jsc (mA/cm²) | 36.19 | 35.68 | 42.31 |
| FF (%) | 77.88 | 76.32 | 73.82 |
| Eff (%) | 18.25 | 17.59 | 20.68 |

Referring to Table 3, when the substrate 310 has an N-type conductivity, the solar cell 100 including the Si-rich SiNx passivation layer 340 according to Experimental Example 6 shows a relatively high efficiency, which is greater by about 2.4 % than Experimental Example 4 and by about 3.1 % than Experimental Example 5. The Si-rich SiNx passivation layer 340 may suffer a tensile horizontal stress, and the N-rich SiNx passivation layer 340 and the PECVD SiO₂ passivation layer 340 may suffer a compressive horizontal stress.

While this disclosure has been described in connection with what is presently considered to be practical example embodiments, it is to be understood that the invention is not limited to the disclosed embodiments, but, on the contrary, is intended to cover various modifications and equivalent arrangements included within the scope of the appended claims.

## Claims

1. A solar cell comprising:
a semiconductor layer including a charge carrier produced therein upon exposure to light; and
a passivation layer on a side of the semiconductor layer, the passivation layer configured to apply a stress to the semiconductor layer and change a mobility of the charge carrier into a direction in the semiconductor layer.

2. The solar cell of claim 1, wherein the semiconductor layer is P-type, and the stress applied to the semiconductor layer is a tensile stress.

3. The solar cell of claim 2, wherein a compressive stress is applied to the semiconductor layer in the direction, and the compressive stress is equal to or higher than 800 MPa.

4. The solar cell of any of claims 1-3, wherein the semiconductor layer is N-type, and the stress applied to the semiconductor layer is a compressive stress.

5. The solar cell of claim 4, wherein a tensile stress is applied to the semiconductor layer in the direction, and the tensile stress is equal to or higher than 4,000 MPa.

6. The solar cell of any of claims 1-5, wherein the charge carrier is electrons.

7. The solar cell of any of claims 1-5, wherein the charge carrier is holes.

8. The solar cell of any of claims 1-7, wherein the passivation layer includes at least one of an oxide, a nitride, amorphous silicon, ZnS, and MgF₂.

9. The solar cell of any of claims 1-8, further comprising:
an anti-reflection coating on another side of the semiconductor layer.

10. The solar cell of claim 9, wherein the anti-reflection coating includes at least one of MgF₂, ZnS, SiNₓ, SiO₂, and Al₂O₃.

11. The solar cell of any of claims 1-10, further comprising:
a first electrode and a second electrode on a surface of the semiconductor layer,
wherein the semiconductor layer is connected to one of the first electrode and the second electrode.

12. The solar cell of claim 11, wherein the first electrode and the second electrode are on opposite sides of the semiconductor layer.

13. The solar cell of claim 11, wherein the first electrode and the second electrode are on a same side of the semiconductor layer.
